# EUROPEAN PATENT APPLICATION

(11) **EP 2 017 898 A1**
(43) Date of publication of application: **21.01.2009**
(21) Application number: 07013974.6
(22) Date of filing: 17.07.2007
(51) Int. Cl.: H01L 33/00

(54) **Semiconductor light-emitting device and method for the manufacture thereof**

(71) Applicant: Vishay Israel Ltd., 20692 Yokneam Illit (IL)
(72) Inventor: Mistele, David, 36811 Nesher (IL); Zaedman, Amir, 20692 Yokneam Illit (IL); Rabinovich, Ilan, 23800 Givat Ela (IL)
(74) Representative: Manitz, Finsterwald & Partner GbR

(57) **Abstract**

The invention relates to a light-emitting semiconductor device, in particular a light-emitting diode, comprising a top contact (7), a conductive carrier (1,2), and a light-emitting film (21), said light-emitting film being disposed between said top contact and said conductive carrier. The light-emitting film or a lower layer disposed between the light-emitting film and the conductive layer has a face (32) facing the conductive carrier, the face having a random surface texture. The invention relates further to a method for the manufacture of such light-emitting semiconductor device.

## Description

The present application relates to an optoelectronic semiconductor device, in particular a light-emitting diode (LED), comprising a top contact, a conductive carrier, and a light-emitting film, the light-emitting film being disposed between the top contact and the conductive carrier. The present application relates further to a method for the manufacture of an optoelectronic semiconductor device.

A conventional LED is based on semiconductor compounds such as GaAs, InP, ZnSe, GaN and their ternary and quaternary compounds including In and Al. A common LED comprises a light-emitting region or light-emitting film grown on a semiconductor compound substrate, e.g. by means of MOCVD, LPE or MBE techniques. The light-emitting film includes a p-n junction. Electrical current generated by two electrodes usually deposited on the bottom and top sides of the device flows through the p-n junction, generating photons whose wavelength depends on the specific semiconductor material. Light is emitted from the light-emitting film in all directions wherein light emitted towards the semiconductor substrate is absorbed by the semiconductor substrate.

A known method for decreasing such absorbance includes growing a thick "window layer" between the substrate and the light-emitting region, increasing the distance between the light-emitting region and the absorbing substrate, the window layer being transparent, absorbing only a minor fraction of the light transmitted through it. However, light emitted towards the substrate will still be absorbed by the substrate. Another known method includes the disposition of internal semiconductor reflection layers such as a Distributed Bragg Reflector (DBR) between the substrate and the light-emitting film. However, a DBR is only partially reflective. Thus, these known methods provide only a partial solution to the absorbing problem.

A further known method includes attaching the substrate with the grown light-emitting region to another semiconductor carrier which is fully transparent to the wavelength of the generated light. The attachment is done such that the original substrate material faces away from the carrier. The absorbing portion can then be removed, leaving behind only the light-emitting region attached to the transparent carrier. Light passing through the transparent carrier may be reflected (and directed) by the device packaging, where the device is attached onto a reflective material. However, this solution is complicated since perfect matching of different semiconductors types is problematic and difficult to achieve at low cost.

In addition, according to Snell's law, only those photons that reach the surface of the film at an angle lower than a critical angle for total reflection (defined by the respective refractive index of the materials at the interface) can exit the light-emitting film. In a three-dimensional view, the photons must reach the surface with an angle within a specific "exit cone" to escape from the light-emitting film. Other photons will be multiply reflected within the film until finally absorbed.

Proceeding from this prior art, it is an object of the present invention to provide an optoelectronic semiconductor device that has improved light extraction efficiency.

This object is achieved in an optoelectronic semiconductor device of the type initially described wherein the light-emitting film or a lower layer disposed between the light-emitting film and the conductive carrier has a face facing the conductive carrier, the face having a random texture.

The random texture results in a diffuse reflection of light at the face of the light-emitting film or the lower layer facing the conductive carrier, randomly changing the travel directions of the photons. Thus, light subject to total reflection at the upper surface of the light-emitting film - the upper surface facing away from the conductive carrier and being provided for coupling out light from the device - will be reflected back to the upper surface via said face at random angles. Therefore, the fraction of photons hitting the upper surface with an angle within the above-explained exit cone is increased. Therefore, the light extraction efficiency of the optoelectronic semiconductor device is improved. Preferably, the lower layer is a window layer.

As used herein, the term "random texture" when referring to a face, surface, or interface is intended to mean that the face, surface, or interface is marked by non-symmetrical structures, including without limitation irregular projections containing inequalities, or ridges, including without limitation numerous and random edges or angles.

According to one exemplary embodiment of the invention, the face has an average roughness (Rₐ) of up to 200 nm (2000Å), in particular between 5 nm (50Å) and 70 nm (700Å). The average roughness is the arithmetic mean or average of the absolute distances of the surface points from the mean plane.

To further increase the light extraction efficiency, the light-emitting film or an upper layer disposed between the top contact and the light-emitting film may include an upper surface facing the top contact, the upper surface having a random surface texture. The light-emitting film and/or said upper layer may include at least one lateral surface, the at least one lateral surface having a random surface texture. Preferably, the upper layer is a window layer or current-spreading layer.

According to a preferred embodiment of the invention, the optoelectronic semiconductor device further comprises a mirror layer disposed between the light-emitting film and the conductive carrier or between the lower layer and the conductive carrier. Said mirror layer (3, 4, 5) may include a face having a random texture which is complementary to said random texture of said face of the light-emitting film or the lower layer. The mirror layer may include a dielectric layer and a two-dimensional array of ohmic contacts extending through the dielectric layer. The mirror layer may further include a first metal layer, the first metal layer being disposed between the dielectric layer and the conductive carrier.

Said face having a random texture may be located between the light-emitting film and the mirror layer. In particular, said face may be located adjoining to the light-emitting film and to the mirror layer, or it may be located adjoining to the lower layer and to the mirror layer. Thus, the mirror layer may be formed directly on the face of the light-emitting film. Alternatively, the mirror layer may be formed directly on the face of the lower layer.

According to another preferred embodiment of the invention, the conductive carrier includes a substrate and/or second metal layer. The conductive carrier may include a third metal layer deposited on the second metal layer, the third metal layer being suited as an intermediate layer for eutectic bonding. However, other bonding techniques can be utilized also, such as employing a high temperature conductive epoxy.

According to still another preferred embodiment of the invention, the optoelectronic semiconductor device further comprises a bottom contact.

The light-emitting film may include an active layer for emitting photons. The light-emitting film may have a thickness of between 5 µm and 50 µm, in particular between 7 µm and 30 µm. The active layer may comprise a III-V compound semiconductor such as AlInGaAs or other optical active layers. The light-emitting film may include two confinement or cladding layers, the active layer being disposed between the confinement layers. The two confinement layers may include a p-type doped III-V compound semiconductor layer and an n-type doped III-V compound semiconductor layer.

The dielectric layer may comprise a low refractive index insulating material such as silicon dioxide and silicon nitride. The dielectric layer may have a thickness of between 30 nm and 500 nm. The ohmic contacts may have a contact diameter, the contact diameter preferably being between 2 µm and 20 µm. The ohmic contacts may comprise at least one of Au and Ag. The first metal layer may have a thickness of preferably between 50 nm and 500 nm. The first metal layer may comprise Au, AuGe, AuZn or Ag. The semiconductor adjacent to the metal layer may be doped to increase its electrical conductivity.

The substrate may comprise solid material having or containing high conductive portion. According to a preferred embodiment of the invention, a III-V compound semiconductor such as GaAs is used. The second metal layer may comprise at least one of AuZn and AuGe. The second metal layer may have a thickness of between 0,100 µm and 0,500 µm. The third metal layer may comprise AuSn. The third metal layer may have a thickness of between 1 µm and 3 µm.

It is also an object of the present invention to provide a method for the manufacture of an optoelectronic semiconductor device of the type described.

This object is satisfied in accordance with the method of the invention comprising forming a multi-layer structure including the steps of forming a light-emitting film on a sacrificial substrate and working a surface of the light-emitting film or a surface of a lower layer formed on the light-emitting film such that the surface has a random surface texture; attaching a conductive carrier to the multi-layer structure; removing the sacrificial substrate; and forming a top contact on the light-emitting film, preferably in this order.

According to a preferred embodiment of the invention, working the surface includes etching the surface, in particular wet etching the surface using wet etchants such as HF, HNO₃ or other chemical etchants.

To further increase light extraction efficiency, the method for the manufacture of an optoelectronic semiconductor device may further comprise, after removing the sacrificial substrate, working an upper surface of the light-emitting film or of an upper layer on the light-emitting film such that the upper surface has a random surface texture. The method may further comprise working at least one lateral surface of the light-emitting film and/or of an upper layer on the light-emitting film such that the at least one lateral surface has a random texture.

According to another preferred embodiment of the invention, forming the multi-layer structure further includes, preferably before removing the sacrificial substrate, forming a mirror layer on the light-emitting film. Forming the mirror layer may include forming a dielectric layer on the light-emitting film, etching contact holes through the dielectric layer, and filling the contact holes with metal. Forming the mirror layer may further include forming a first metal layer on the dielectric layer.

According to still another preferred embodiment of the invention, the method for the manufacture of an optoelectronic semiconductor device further comprises forming the conductive carrier, wherein forming the conductive carrier includes forming a second metal layer on a substrate. The step of forming the conductive carrier may further include forming a third metal layer on the second metal layer, the third metal layer being suited for eutectic bonding.

According to yet another preferred embodiment of the invention, attaching the conductive carrier to the multi-layer structure includes eutectic bonding or glue bonding.

According to a further preferred embodiment of the invention, removing the sacrificial substrate includes etching or removing the sacrificial substrate, in particular wet etching the sacrificial substrate using wet etchants such as a H₂SO₄:H₂O₂:H₂O solution. Other solutions can also be used. According to still another preferred embodiment of the invention, the sacrificial substrate may be removed using a mechanical lapping process, or a combination of mechanical and chemical process. According to one exemplary embodiment of the invention, the method for the manufacture of an optoelectronic semiconductor device further comprises forming a bottom contact under the conductive carrier.

The step of forming said light-emitting film may include forming an active layer for emitting photons. The step of forming said light-emitting film may alternatively or additionally include forming two confinement layers, said active layer being disposed between said confinement layers.

The present invention is best understood from the following detailed description when read in connection with the accompanying drawing. Included in the drawing are the following figures:
- Fig. 1: is a cross-section of a conventional light-emitting film grown on a semiconductor substrate.
- Fig. 2: is a cross-section of a light-emitting film grown on a sacrificial semiconductor substrate, the light-emitting film having a random textured surface.
- Fig. 3: shows the light-emitting film of fig. 2 with a dielectric film, a metal film, and metal-semiconductor contact areas.
- Fig. 4: is a cross-section of a conductive carrier including a substrate and a metal layer.
- Fig. 5: shows the light-emitting film of fig. 3 attached to the conductive carrier of fig. 4.
- Fig. 6: is a cross-section of an optoelectronic semiconductor device according to one exemplary embodiment of the present invention.
- Fig. 7: is is a cross-section of an optoelectronic semiconductor device according to another exemplary embodiment of the present invention.

It is noted that for simplicity and clarity of illustration, elements illustrated in the figures have not necessarily been drawn to scale. In addition, like reference numerals are used among the figures to indicate corresponding or analogous elements.

The invention will be described in the context of a GaAs compound with an AlGaAs light-generating film which is typical for light-emitting diodes at about 870 nm to 890 nm wavelength, but the same can be applied to optoelectronic semiconductor devices composed of other materials including the basic compound materials mentioned above which partially or completely absorb the generated light.

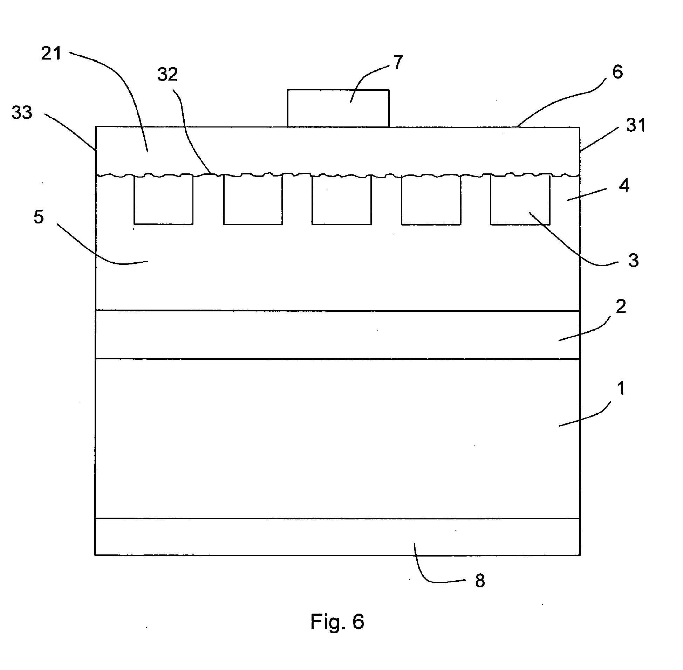

The light-emitting diode shown in fig. 6 comprises, from top to bottom, a top contact 7, a light-emitting film 21, a mirror layer 3, 4, 5, a conductive carrier 1, 2, and a bottom contact 8. The mirror layer 3, 4, 5 includes a first metal layer 5 and a dielectric layer 3 on top of the first metal layer 5. An array of ohmic contacts 4 extends through the dielectric layer 3. The conductive carrier 1, 2 includes a substrate 1 and a second metal layer 2 on top of the substrate 1. The interface 32 between the light-emitting film 21 and the mirror layer 3, 4, 5 comprises a random texture provided for randomly reflecting light generated within light-emitting film 21.

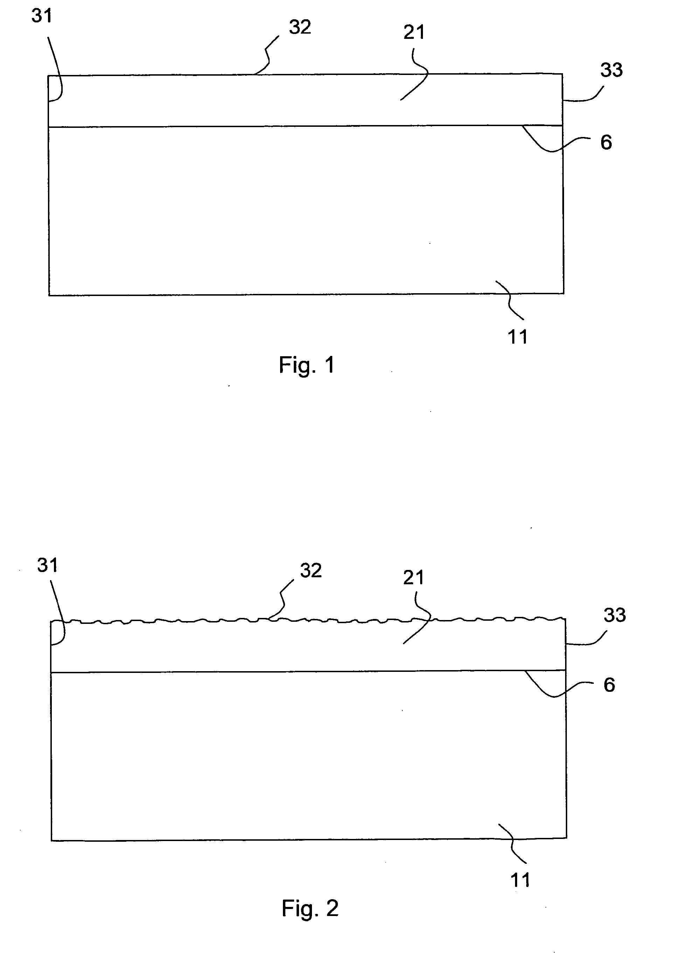

Referring to figs. 1 to 6, an exemplary method is provided for the manufacture of an optoelectronic semiconductor device.

In a production line, manufacturing light-emitting diodes is performed based on wafers having a thickness of typically 200 µm to 500 µm wherein a large amount of single chips is singularized by cutting the wafer after the manufacturing steps are completed. For the sake of simplicity, a single chip is shown in the figures.

Fig. 1 shows a conventional chip. In a first step, a light-emitting film 21 having a thickness of typically 7 µm to 30 µm is grown on a GaAs substrate 11. The light-emitting film 21 includes an active (light-generating) AlGaAs layer (not shown) and semiconducting layers of types n and p (not shown). When current flows through the device, light is generated in film 21. The light which hits the compound-air interface at an angle outside the exit cone is reflected from surfaces 31, 32, and 33 of the light-emitting film 21. Moreover, light directed towards interface 6 which is disposed between the light-emitting film 21 and the substrate 11 is fully absorbed by the substrate 11.

According to the invention, the conventional chip as shown in fig. 1 is modified such that the surface 32 comprises a random surface texture as shown in fig. 2. Surface texturing preferably is performed by treating the wafer in HF, HNO3 or other chemical etchants using conventional methods, and typically generates a random surface morphology having an average roughness of 5 nm (50Å) to 70 nm (700Å). Light reflected from the textured surface back into the film is randomly distributed at different angles. Therefore, this morphology increases the probability that light which hits the surface 32 will exit the light-emitting film 21 (hitting the surface 32 at an angle within the "exit cone").

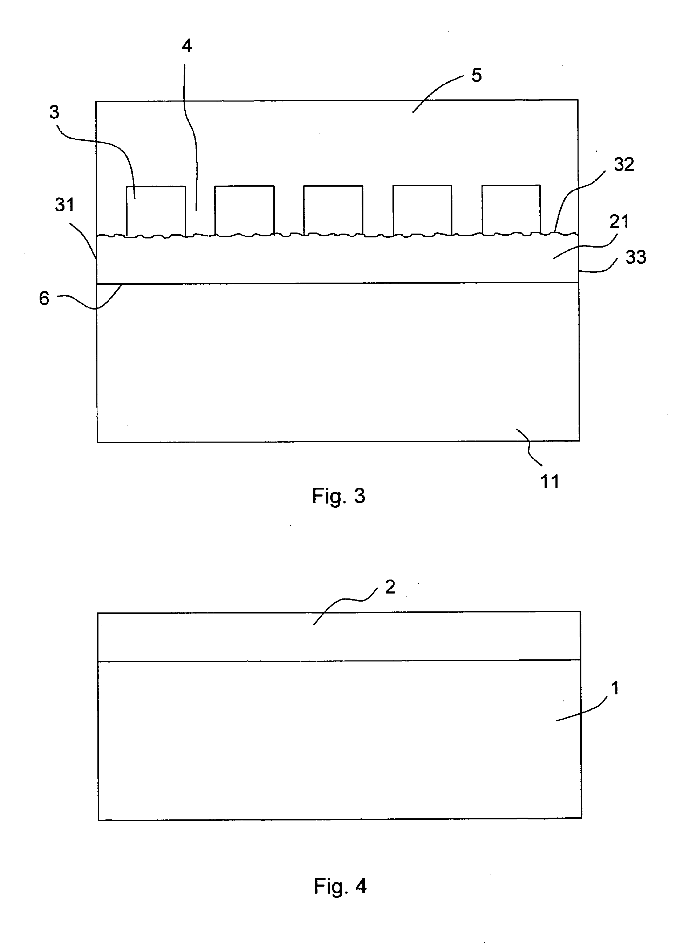

In a next step, a mirror film 3, 4, 5 is formed as shown in fig. 3. It should be noted that the face of the mirror film 3, 4, 5 directed towards the light-emitting film 21 has a random texture complementary to the random texture of the surface 32 of the light-emitting film 21, i.e. the mirror film 3, 4, 5 and the light-emitting film 21 are in direct contact all over the surface 32.

For this purpose, a dielectric film 3 such as SiO₂ or Si₃N₄ is deposited on top of textured surface 32 using conventional methods such as PECVD. The thickness of the dielectric film 3 is typically between 0,03 µm and 0,5 µm. Electrical current flow into the semiconductor material 21 requires definition of contact areas. This is accomplished by etching contact holes 4 in the dielectric film 3. The contact holes 4 having a contact diameter of typically 2 µm to 20 µm are created by a conventional lithography technique followed by either using a chemical etchant such as HF or using a plasma etch tool. Once the contact holes 4 are defined, a reflective metal 5 is deposited using a conventional metal deposition tool. Metal layer 5 may comprise Au or Ag in order to form a highly reflective mirror. Metal layer 5 includes a barrier metal for eliminating diffusion of material towards the semiconductor interface 32. A typical metal structure for a p-type contact would be an AuZn/TiW scheme with a total thickness of 0,1 µm to 0,5 µm. The combination of reflective metal layer 5 with a suitable dielectric layer 3 results in a highly reflective mirror. The textured pattern 32 covered by reflective mirror layer 3, 4, 5 provides a "diffuse mirror" which randomly reflects light generated in light-emitting film 21 in all directions.

Referring to fig. 4, the conductive carrier 1, 2 onto which the chip of fig. 3 will be bonded is described. A metal layer 2 is deposited onto a conductive GaAs wafer substrate 1. The metal layer 2 is a conventional metal electrode structure normally used for GaAs substrates such as AuZn for p-type material or AuGe for n-type material having a thickness of typically 0,1 µm to 0,5 µm. On top of metal layer 2, another metal layer (not shown) having a thickness of typically 1 µm to 5 µm may be deposited which other metal layer comprises material needed for eutectic bonding such as AuSn.

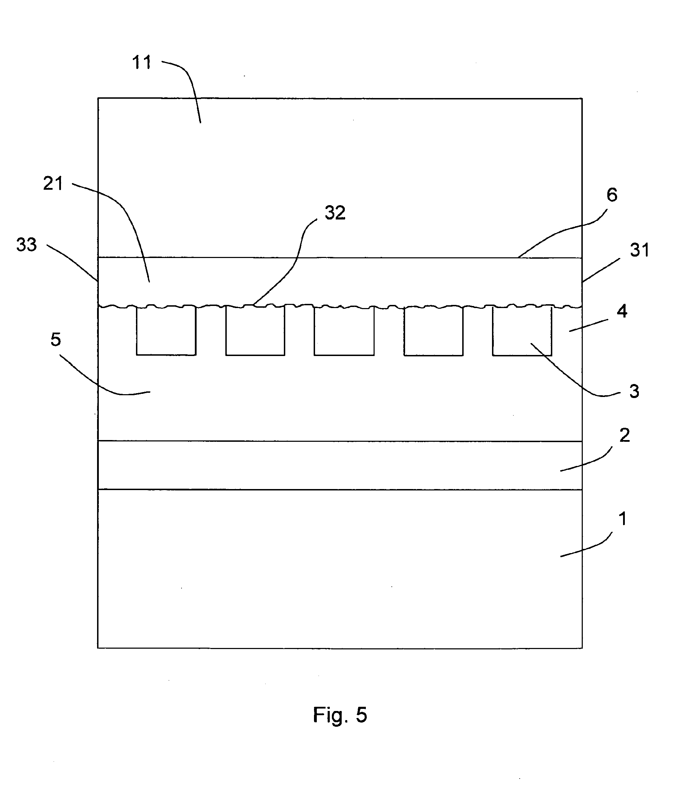

Wafer bonding is accomplished for example by using an eutectic bonding process. For this, the chip shown in fig. 3 is flipped such that the GaAs substrate 11 is pointing upwards. The metal layer 5 of the chip of fig. 3 and the metal layer 2 of the conductive carrier of fig. 4 are then attached to each other as shown in fig. 5. Wafer bonding is performed in a thermal oven in an inert atmosphere and by applying a controlled pressure on the combined chip.

Following wafer bonding, the light absorbing GaAs substrate 11 is removed using conventional etching chemicals such as a H₂SO₄:H₂O₂:H₂O solution or a mechanical lapping technique (fig. 6). In a final step, a bottom electrode 8 and a top electrode 7 are added using conventional techniques of lithography and metal electrode formation.

The final chip comprises a light-emitting region 21, a diffusely reflecting mirror interface 32, a conductive carrier substrate 1, a bottom electrode 8 and a top electrode 7. The light generated in region 21 is either escaping out of the device when hitting the surface 6 with an angle within the exit cone, or is reflected back towards the diffuse mirror 32. Light hitting the diffuse mirror 32 is reflected back at arbitrary angles. Since region 21 is transparent, light can be reflected many times in arbitrary angles, until hitting surface 6 with an angle within the exit cone. Hereby, the light extraction efficiency at the front surface 6 of the light-emitting film 21 is increased by up to 60% compared to a conventional mirror scheme. The total light extraction efficiency can be further increased by performing texturing also to surfaces 6, 31 and 33 using conventional surface texturing methods.

Summarizing, an optoelectronic semiconductor device that increases the light extraction efficiency of a light-emitting region 21 attached to a metallic holder 2, 5 and a method for producing such an optoelectronic semiconductor device are described. The light-emitting region 21 having a thickness of 5 µm to 50 µm is grown on a semiconductor compound substrate 11 by means of MOCVD, LPE or MBE techniques. A chemical solution is used to create a random texturing effect on the exposed side 32 of the light-emitting region 21. A mirror layer 3, 4, 5 is formed on top of the textured surface 32 by deposition of a dielectric layer 3 and of a reflective metal film 5 such as Au, AuGe or AuZn. Contact holes 4 are formed in the dielectric layer 3 before metal deposition, allowing conductance of electrical current into the semiconductor film 21. The total area of the contact holes 4 is small compared to the mirror area 32. The device is bonded onto a conductive carrier 1, 2 with the metallic side 5 facing the conductive carrier 1, 2, creating an electrical electrode. The semiconductor substrate 11 is then removed so that it is only the light-emitting region 21 that remains attached to the carrier 1, 2. A metal electrode 7 is disposed on the opposite side of the carrier electrode 1, 2, with dimensions that are smaller than the semiconductor area 21, allowing emission of light from the area not covered by the electrode 7.

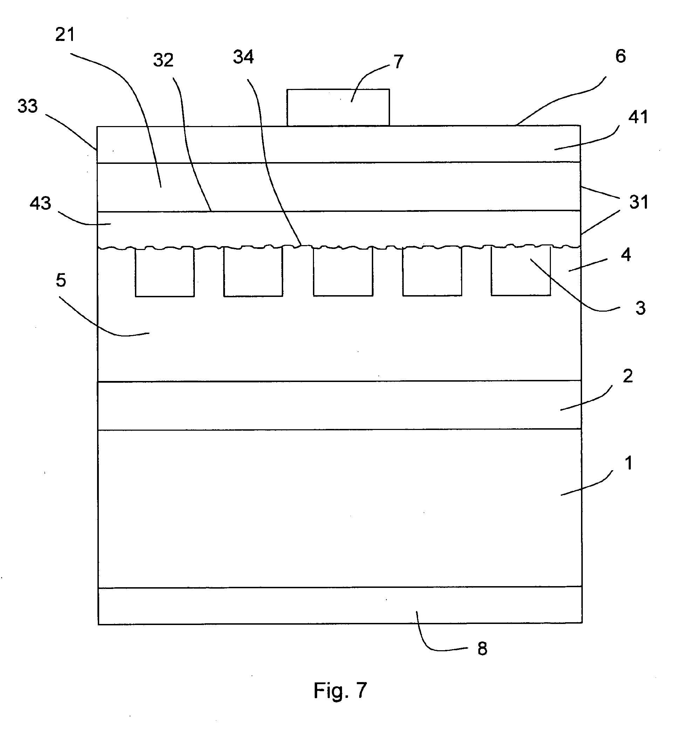

The light-emitting diode according to the invention may additionally comprise an upper window layer and/or a lower window layer. The light-emitting diode shown in fig. 7 additionally comprises an upper window layer 41 disposed between the top contact 7 and the light-emitting film 21, and a lower window layer 43 disposed between the light-emitting film 21 and the mirror layer 3, 4, 5. The upper and lower window layers 41, 43 are transparent for the light generated in the light-emitting film 31. Upper window layer 41 may function as a current-spreading layer to spread the current under the top contact 7 to regions not covered by the opaque top contact 7.

In contrast to the optoelectronic semiconductor device according to figs. 1 to 6, the lower face 32 of the light-emitting film 21 of the optoeclectronic semiconductor device according to fig. 7 does not have a random texture. Rather, the lower face 34 of the lower window layer 43 has a random texture, i.e. the interface 34 between the lower window layer 43 and the mirror layer 3, 4, 5 comprises a random texture provided for randomly reflecting light generated within light-emitting film 21.

For the manufacture of the optoelectronic semiconductor device according to fig. 7, lower window layer 43 is formed on the light-emitting layer 21. Subsequently, the exposed surface 34,of the lower window layer 43 is treated similarily to the surface 32 of the light-emitting film 21 in fig. 2. The upper window layer 41 is formed on the sacrificial substrate 11, prior to formation of the light-emitting film 21 on the upper window layer 41.

## Claims

1. An optoelectronic semiconductor device, in particular a light-emitting diode, comprising:
a top contact (7),
a conductive carrier (1, 2), and
a light-emitting film (21), said light-emitting film (21) being disposed between said top contact (7) and said conductive carrier (1, 2),
**characterized in that**
said light-emitting film (21) or a lower layer (43) disposed between said light-emitting film (21) and said conductive carrier (1, 2) has a face (32, 34) facing said conductive carrier (1, 2), said face (32, 34) having a random texture.

2. The optoelectronic semiconductor device of claim 1, wherein said face (32, 34) has an average roughness of up to 200 nm, in particular between 5 nm and 70 nm.

3. The optoelectronic semiconductor device of claim 1 or claim 2, wherein said light-emitting film (21) or an upper layer (41) disposed between said top contact (7) and said light-emitting film (21) includes an upper surface (6) facing said top contact (7), said upper surface (6) having a random surface texture.

4. The optoelectronic semiconductor device of one of the preceding claims, wherein said light-emitting film (21) and/or an upper layer (41) disposed between said top contact (7) and said light-emitting film (21) includes at least one lateral surface (31, 33), said at least one lateral surface (31, 33) having a random surface texture.

5. The optoelectronic semiconductor device of one of the preceding claims, further comprising a mirror layer (3, 4, 5) disposed between said light-emitting film (21) and said conductive carrier (1, 2) or between said lower layer (43) and said conductive carrier (1, 2).

6. The optoelectronic semiconductor device of claim 5, wherein said mirror layer (3, 4, 5) is disposed in direct contact to said face (32, 34) of said light-emitting film (21) or said lower layer (43).

7. The optoelectronic semiconductor device of claim 5 or claim 6, wherein said mirror layer (3, 4, 5) includes a face having a random texture which is complementary to said random texture of said face (32, 34) of said light-emitting film (21) or said lower layer (43).

8. The optoelectronic semiconductor device of one of claims 5 to 7, wherein said mirror layer (3, 4, 5) includes a dielectric layer (3) and an array of ohmic contacts (4) extending through said dielectric layer (3).

9. The optoelectronic semiconductor device of claim 8, wherein said mirror layer (3, 4, 5) includes a first metal layer (5), said first metal layer (5) being disposed between said dielectric layer (3) and said conductive carrier (1, 2).

10. The optoelectronic semiconductor device of one of the preceding claims, wherein said conductive carrier (1, 2) includes a substrate (1).

11. The optoelectronic semiconductor device of claim 13, wherein said conductive carrier (1, 2) includes a second metal layer (2).

12. The optoelectronic semiconductor device of claim 13, wherein said conductive carrier (1, 2) includes a third metal layer deposited on said second metal layer (2), said third metal layer being suited for eutectic bonding.

13. The optoelectronic semiconductor device of one of the preceding claims, further comprising a bottom contact (8).

14. A method for the manufacture of an optoelectronic semiconductor device, in particular a light-emitting diode, comprising:
forming a multi-layer structure (3, 4, 5, 11, 21) including the steps of
forming a light-emitting film (21) on a sacrificial substrate (11) and
working a surface (32) of said light-emitting film (21) or a surface (34) of a lower layer (43) formed on said light-emitting film (21) such that said surface (32, 34) has a random surface texture;
attaching a conductive carrier (1, 2) to said multi-layer structure (3, 4, 5, 11,21);
removing said sacrificial substrate (11); and
forming a top contact (7) on said light-emitting film (21).

15. The method of claim 14, wherein working said surface (32, 34) includes etching said surface (32, 34), in particular wet etching said surface (32, 34).

16. The method of claim 14 or claim 15, further comprising, after removing said sacrificial substrate (11), working an upper surface (6) of said light-emitting film (21) or of an upper layer (41) on said light-emitting film (21) such that said upper surface (6) has a random surface texture.

17. The method of one of claims 14 to 16, further comprising, after removing said sacrificial substrate (11), working at least one lateral surface (31, 33) of said light-emitting film (21) and/or at least one lateral surface of an upper layer (41) on said light-emitting film (21) such that said at least one lateral surface (31, 33) has a random surface texture.

18. The method of one of claims 14 to 17, wherein forming said multi-layer structure (3, 4, 5, 11, 21) further includes forming a mirror layer (3, 4, 5) on said light-emitting film (21) or on said lower layer (43) formed on said light-emitting film (21).

19. The method of claim 18, wherein forming said mirror layer (3, 4, 5) includes
forming a dielectric layer (3) on said light-emitting film (21) or on said lower layer (43) formed on said light-emitting film (21),
etching contact holes through said dielectric layer (3), and
filling said contact holes with metal.

20. The method of claim 19, wherein forming said mirror layer (3, 4, 5) further includes forming a first metal layer (5) on said dielectric layer (3).

21. The method of one of claims 14 to 20, further comprising forming said conductive carrier (1, 2), wherein forming said conductive carrier (1, 2) includes forming a second metal layer (2) on a substrate (1).

22. The method of claim 21, wherein forming said conductive carrier (1, 2) further includes forming a third metal layer on said second metal layer (2), said third metal layer being suited for eutectic bonding.

23. The method of one of claims 14 to 22, wherein attaching said conductive carrier (1, 2) to said multi-layer structure includes eutectic bonding or glue bonding.

24. The method of one of claims 14 to 23, wherein removing said sacrificial substrate (11) includes etching said sacrificial substrate (11), in particular wet etching said sacrificial substrate (11).

25. The method of one of claims 14 to 24, further comprising forming a bottom contact (8) under said conductive carrier (1, 2).
